Europäisches Patentamt

European Patent Office

Office européen des brevets

(19)

(11) Veröffentlichungsnummer : **0 018 349**
**B1**

(12) **EUROPÄISCHE PATENTSCHRIFT**

(45) Veröffentlichungstag der Patentschrift :
**11.05.83**

(21) Anmeldenummer : **80890033.6**

(22) Anmeldetag : **12.03.80**

(51) Int. Cl.³ : **G 01 K   7/00, G 01 K   1/02,**
**H 03 K 13/20, H 03 K   7/00,**
**G 01 D   5/244**

(54) **Schaltungsanordnung zum Umwandeln eines Stromes in Impulse einer der Stromstärke entsprechenden Einschaltdauer, Periodendauer oder Frequenz.**

(30) Priorität : **21.03.79 AT 2134/79**

(43) Veröffentlichungstag der Anmeldung :
**29.10.80 Patentblatt 80/22**

(45) Bekanntmachung des Hinweises auf die Patenterteilung : **11.05.83 Patentblatt 83/19**

(84) Benannte Vertragsstaaten :
**AT DE FR GB**

(56) Entgegenhaltungen :
**DE A 2 411 990**
**DE A 2 440 961**
**DE A 2 618 378**
**DE B 1 254 186**
**US A 3 543 184**
**US A 3 851 191**
**ELEKTRONIK, Heft 4, 1977 H.-U. SCHOLZ « Zeitgeberschaltung störsicher aufgebaut » Seiten 52 bis 54**
**ELEKTRONIK, Heft 1, 1975 A. HILLERS « Stromgesteuerte Monoflop-Schaltungen » Seiten 72-74**
**ELECTRONIC DESIGN, Band 26, Nr. 18, September 1978 W. G. JUNG « Sense Temperature Remotely with IC Temperature/Current Transducers » Seite 138**

(73) Patentinhaber : **Friedmann & Maier Aktiengesellschaft**
**Friedmannstrasse 7**
**A-5400 Hallein bei Salzburg (AT)**

(72) Erfinder : **Pacha, Franz, Dipl.Ing.**
**Preindlgasse 19**
**A-1130 Wien (AT)**
Erfinder : **Brasseur, Georg, Dipl.Ing.**
**Eisslergasse 20**
**A-1130 Wien (AT)**

(74) Vertreter : **Kretschmer, Adolf, Dipl.-Ing.**
**Schottengasse 3a**
**A-1014 Wien (AT)**

EP 0 018 349 B1

## Schaltungsanordnung zum Umwandeln eines Stromes in Impulse einer der Stromstärke entsprechenden Einschaltdauer, Periodendauer oder Frequenz

Die Erfindung betrifft eine Schaltungsanordnung zum Umwandeln eines Stromes in Impulse einer der Stromstärke entsprechenden Einschaltdauer, Periodendauer oder Frequenz, welcher Strom den zeitbestimmenden Kondensator eines monostabilen Multivibrators auflädt, wobei der Kondensator, nachdem die an ihm entsprechend der Ladung ansteigende Spannung einen Schwellenwert erreicht, wieder entladen wird und der Ladestrom von einer physikalischen Meßgröße, beispielsweise einer Temperatur, abhängig ist. Derartige Schaltungsanordnungen eignen sich zum Umwandeln von Stromsignalen in digital verwertbare Signale.

Für die Temperaturmessung ist es bereits bekannt, NTC-Widerstände zu verwenden, deren temperaturabhängiger Widerstandswert bei konstanter Versorgungsspannung temperaturabhängige Ströme fließen läßt, welche in der oben erwähnten Schaltungsanordnung in digital verwertbare Signale umgewandelt werden können. Bei solchen Temperaturmeßschaltungen besteht aber die Gefahr einer Einstreuung von Störspannungen und damit einer Verzerrung der Meßwerte.

Aus dem Artikel « Stromgesteuerte Monoflop-Schaltungen » in der Zeitschrift ELEKTRONIK 1975 Heft 1, S. 72-74, sind verschiedene Schaltungsanordnungen unter Verwendung des integrierten Zeitgebers NE 555 als monostabile Kippstufe bekannt, wobei der Ladestrom dem zugehörigen Kondensator entweder über einen an eine Spannungsquelle angeschlossenen Widerstand oder zur Erzielung eines zeitproportionalen Anstieges der Spannung am Kondensator als eingeprägter Strom zugeführt wird. Eine Kombination des Zeitgebers mit einer Stromquellenschaltung für den Kondensator zeigt Bild 2 des Artikels. Eine Schaltung des integrierten Zeitgebers als nachtriggerbare monostabile Kippstufe ist in Bild 4 des Artikels dargestellt, wobei für diesen Zweck der Triggereingang des Zeitgebers über einen Inverter und der Ausgang des Zeitgebers unmittelbar an die beiden Eingänge eines NAND-Gatters mit offenem Kollektorausgang angeschlossen sind, und der Ausgang des NAND-Gatters an den Kondensator der Zeitgeberschaltung angeschlossen ist. Bei Ausgangspotential H bewirkt dann jeder Triggerimpuls eine Entladung des Kondensators, so daß die Dauer des Ausgangsimpulses vom letzten Triggerimpuls bestimmt wird. Es ist dies somit eine Schaltung für Fremdtaktung, welche nicht dahingehend ausgelegt ist, bei Erreichen eines vorbestimmten Spannungspegels am Kondensator sich selbst zu triggern.

Dem Artikel « Sense temperature remotely with IC temperature/current transducers » in der Zeitschrift ELECTRONIC DESIGN 18, September 1, 1978, S. 138, ist die Anregung zu entnehmen, dem Kondensator eines integrierten Strom-Frequenzwandlers, der diesem Kondensator einen konstanten eingeprägten Strom anbietet, einen Temperatur-Stromumformer parallel zu schalten, dessen Strom der absoluten Temperatur proportional ist. An der Ausgangleitung des Strom-Frequenzwandlers wird eine der gemessenen Temperatur proportionale Frequenz abgegeben, diese Ausgangleitung kann aber in umgekehrter Richtung zu Steuerungszwecken nicht ausgenützt werden.

Die Erfindung zielt darauf ab, eine Schaltungsanordnung der eingangs angegebenen Art in der Weise auszugestalten, daß ihre einzige Ausgangsleitung, über welche Impulse abgegeben werden, deren Einschaltdauer, Periodendauer oder Frequenz ein Maß für eine physikalische Meßgröße darstellt, auch in umgekehrter Richtung zur Übermittlung von Befehls- oder Steuersignalen an die Schaltungsanordnung ausnützbar ist. Die Lösung dieser Aufgabe ist Gegenstand des Anspruchs 1. Die angestrebte Funktion wird durch die äußere Beschaltung des voraussetzungsgemäß zum Umwandeln eines Stromes in Impulse verwendeten monostabilen Multivibrators erzielt und ermöglicht ein Zusammenwirken der erfindungsgemäßen Schaltungsanordnung beispielsweise mit einem Mikroprozessorsystem über eine einzige Verbindungsleitung in besonders einfacher Art und Weise.

Zur Verringerung der Trigger-6 bzw. Totzeit ist es erforderlich, den Kondensator rasch zu entladen, bevor die Anordnung wieder betriebsbereit wird. Vorzugsweise ist daher dem Kondensator ein externer Transistor als Entladeschalter parallelgeschaltet. Ein solcher externer Transistor kann im Gegensatz zu einem in einem den monostabilen Multivibrator bildenden integrierten Schaltkreis gegebenenfalls vorhandenen Entladetransistor beliebig groß dimensioniert werden, wodurch die Totzeit wesentlich herabgesetzt werden kann.

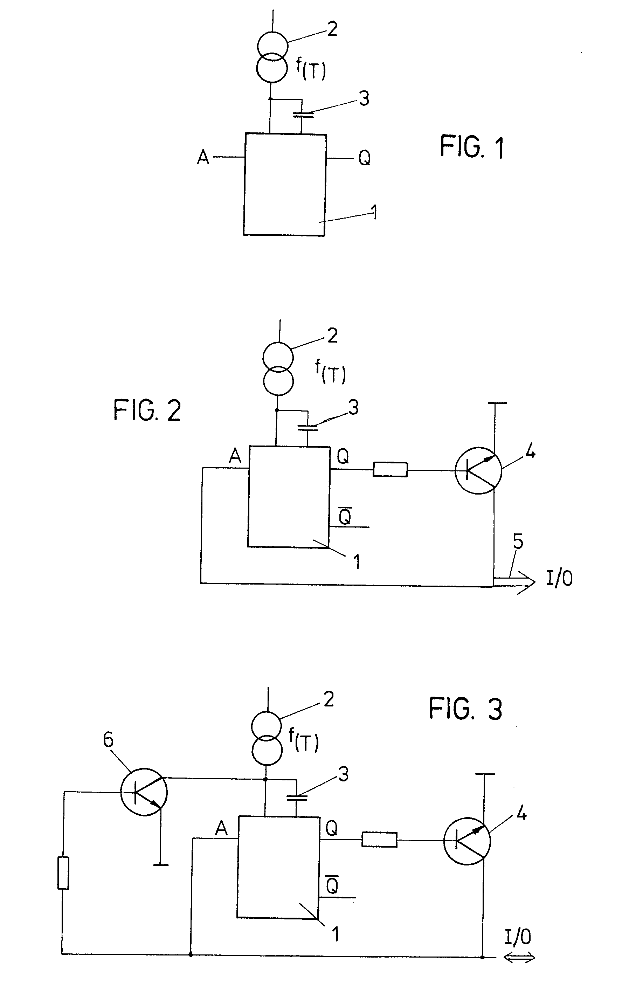

Die erfindungsgemäße Schaltungsanordnung ist nachfolgend an Hand von in der Zeichnung dargestellten Ausführungsbeispielen näher erläutert. In dieser zeigen Fig. 1 eine erste Schaltungsanordnung, Fig. 2 eine erfindungsgemäße Schaltungsanordnung zur Verwendung mit einem Mikroprozessor ($\mu$P) mit bidirektionalem Port und Fig. 3 eine Schaltungsanordnung entsprechend Fig. 2 mit verkürzter Totzeit.

In Fig. 1 ist mit 1 ein monostabiler Multivibrator bezeichnet. 2 stellt eine temperaturabhängige Stromquelle dar, durch welche der zeitbestimmende Kondensator 3 des Multivibrators 1 aufgeladen wird. Ein 1 → $\emptyset$ Übergang am Triggereingang A löst den Monoflop aus. Da die Stromstärke i = f (T) fest vorgegeben ist, ist der Kondensator 3 ausschlaggebend für die Zeitkonstante. Der Ausgang Q geht in den Zustand 1 über und nach Erreichen des Schwellenwertes geht Q → $\emptyset$. Die Meßzeit $\tau$ ist dem Reziprokwert der Temperatur hiebei im wesentlichen proportional. Wenn der Ausgang Q nicht mit dem Eingang A elektrisch verbunden ist, sind. zwei Signalleitungen zur Funktion erforderlich.

In Fig. 2 ist der Ausgang Q mit dem Eingang A über einen als Inverter geschalteten Transistor 4 verbunden. Es ist hier nur eine Signalleitung 5 erforderlich und diese Leitung kann unmittelbar an ein bidirektionales Port eines μP zur Auswertung der Impulse gelegt werden. Der Inverter hält das beispielsweise vom μP vorgegebene Signal $U_A$ an A auf Null bis $Q \rightarrow \emptyset$. Erst dann geht A endgültig $\emptyset \rightarrow 1$. Die Zeit, während welcher $U_A \rightarrow \emptyset$ ist hier die Meßzeit und wiederum charakteristisch für die die Stromquelle beeinflussende physikalische Meßgröße.

Nach der Meßzeit $\tau_M$ fällt die Spannung am Kondensator expontiell ab. Durch den in Fig. 3 zusätzlich vorgesehenen Transistor 6 kann der Kondensator 3 im nichtgetriggerten Zustand rasch entladen und auf Nullpotential gehalten werden, wodurch die Schaltungsanordnung sehr rasch wieder betriebsbereit wird.

Die Schaltungsanordnung eignet sich bevorzugt in Digitalschaltungen und insbesondere als μP-Peripherie. Es ist keine direkte A-D-Wandlung mittels A-D-Konvertern oder D-A-Konvertern nötig. Der Strom wird gequantelt gemessen. Durch die Verwendung einer Stromquelle als Sensor kann der Sensor räumlich vom Multivibrator und vom μP getrennt sein, ohne daß Störeinflüsse wirksam werden.

### Ansprüche

1. Schaltungsanordnung zum Umwandeln eines Stromes in Impulse einer der Stromstärke entsprechenden Einschaltdauer, Periodendauer oder Frequenz, welcher Strom den zeitbestimmenden Kondensator (3) eines monostabilen Multivibrators (1) auflädt, wobei der Kondensator (3), nachdem die an ihm entsprechend der Ladung ansteigende Spannung einen Schwellenwert erreicht, wieder entladen wird und der Ladestrom von einer physikalischen Meßgröße, beispielsweise einer Temperatur abhängig ist, dadurch gekennzeichnet, daß der Triggereingang (A) des Multivibrators (1) mit dem Ausgang (Q) desselben über einen Inverter (4) verbunden ist und daß diese Verbindung an eine bidirektionale Ein-/Ausgangsleitung (5) angeschlossen ist.

2. Schaltungsanordnung nach Anspruch 1, dadurch gekennzeichnet, daß dem Kondensator (3) ein externer Transistor (6) als Entladeschalter parallelgeschaltet ist.

### Claims

1. Electrical circuit for converting a current into pulses, the duration, repetition period or frequency of which corresponds to the current amplitude, said current charging the time function capacitor (3) of a monostable multivibrator (1), the capacitor (3) being discharged after its voltage rising in accordance with charge has reached a threshold value, and the charging current being dependent on a physical magnitude to be measured, for example a temperature, characterized in that the trigger input (A) of the multivibrator (1) is connected to its output (Q) via an inverter (4), and that this interconnection is connected to a bidirectional in-/output line (5).

2. Electrical circuit as claimed in claim 1, characterized in that an external transistor (6) forming a discharge switch is connected in parallel with the capacitor (3).

### Revendications

1. Agencement de circuit pour convertir un courant en impulsions ayant une durée de mise en circuit, une durée de période ou une fréquence correspondant à l'intensité du courant, ledit courant assurant la charge d'un condensateur de détermination de temps (3) d'un multivibrateur monostable (1), ledit condensateur (3) après que la tension appliquée sur lui, croissante en fonction de la charge, a atteint une valeur de seuil, étant à nouveau déchargé et le courant de charge étant dépendant d'une grandeur de mesure physique, par exemple une température, caractérisé par le fait que l'entrée de déclenchement (A) du multivibrateur (1) est reliée à la sortie (Q) de celui-ci au travers d'un inverseur (4) et que cette liaison est raccordée à une ligne d'entrée/sortie bidirectionnelle (5).

2. Agencement de circuit selon la revendication 1, caractérisé par le fait qu'un transistor externe (6) est monté en parallèle avec le condensateur (3) en tant que commutateur de décharge.

FIG. 1

FIG. 2

FIG. 3